# EUROPEAN PATENT SPECIFICATION

(11) **EP 2 395 565 B1**
(45) Date of publication and mention of the grant of the patent: **19.04.2017**
(21) Application number: 09839669.0
(22) Date of filing: 09.02.2009
(51) Int. Cl.: H01L 31/072, H01L 31/0352, B82Y 30/00, H01L 31/04, H01L 31/0304, H01L 31/0735

(54) **SOLAR CELL**
SOLARZELLE
PILE SOLAIRE

(43) Date of publication of application: 14.12.2011
(73) Proprietor: TOYOTA JIDOSHA KABUSHIKI KAISHA, Toyota-shi, Aichi-ken, 471-8571 (JP)
(72) Inventor: FUKADA, Yoshiki, Toyota-shi Aichi-ken 471-8571 (JP)
(74) Representative: Winter, Brandl, Fürniss, Hübner, Röss, Kaiser, Polte - Partnerschaft mbB
(86) International application number: PCT/JP2009/052160
(87) International publication number: WO 2010/089892

(56) References cited:
- JP-A- 9 237 908
- JP-A- 2002 141 531
- JP-A- 2006 114 815
- JP-A- 2006 114 815
- US-A1- 2008 011 349

## Description

### Technical Field

The present invention relates to a solar cell as claimed in claim 1; more particularly, it relates to a solar cell employing wetting layer(s) and quantum dots.

### Background Art

Solar cells have advantages in view that CO₂ emission per power generation is smaller and no fuel for power generation is required. So, studies regarding various types of solar cell have been developed actively. Currently, among solar cells in practical use, mono-junction solar cells having a set of pn junction and using single-crystal silicon or polycrystal silicon have been major. However, theoretical limitation of photoelectric conversion efficiency of the mono-junction solar cell (hereinafter, referred to as "theoretical efficiency limit".) stays at about 30%; therefore, a new method to further improve the theoretical efficiency limit has been studied.

One of the possible new methods so far is a solar cell employing quantum dots of semiconductor (hereinafter, referred to as "quantum dot solar cell".). The quantum dot used in the quantum dot solar cell is a semiconductor nanocrystal having a dimension of about 10 nm, which can three-dimensionally lock electrons and holes both generated by irradiation of light (hereinafter, these may be referred to as "carrier" as a whole.). By locking electrons in each quantum dot, a property of electron as a quantum-mechanical wave can be used; so, it is possible to absorb a band of solar spectrum which cannot be absorbed by a conventional solar cell. In addition, by the quantum dot solar cell, it is possible to reduce energy to be lost in the form of heat. Thereby, with such a quantum dot solar cell, it is presumably possible to improve the theoretical efficiency limit up to 60% or more.

As a technique related to a quantum dot solar cell, for example, Patent document 1 discloses a solar cell characterized by being formed of a pin structure and including quantum dots which has three-dimensional locking effect in i-layer as a photodetecting layer, and characterized in that the energy band structure of the quantum dots and the surrounding barrier layer is Type-II. In addition, as a technique related to an optical semiconductor device employing quantum dots, for example, Patent document 2 discloses an optical semiconductor device employing a stacked body in which self-assembled quantum dots produced layers are stacked. Moreover, as a technique related to a semiconductor laser employing quantum dots, for example, Patent document 3 discloses a quantum dot semiconductor laser characterized by the energy potential structure for shortening the carrier relaxation time in the quantum dots.

Patent Document 1: Japanese Patent Application Laid-Open (JP-A) No. 2006-114815
Patent Document 2: JP-A No. 11-330606
Patent Document 3: JP-A No. 2006-295219

Moreover, document US 2008/0011349 A1 describes a photovoltaic device which includes one or more structures, an array of quantum dots, at least one groove, and at least one conductor. Each of the structures comprises an intrinsic layer on one of an n type layer and a p type layer and the other one of them on the intrinsic layer. The array of quantum dots is located in the intrinsic layer in at least one of the structures. The groove extends into at least one of the structures and the at least one conductor is located along at least a portion of the groove.

### Disclosure of the Invention

### Problems to be solved by the Invention

The technique disclosed in the Patent document 1 employs quantum dots, so that it is possible to three-dimensionally and tightly lock the carriers. As a result, because of the phonon bottleneck effect, it is assumed that energy loss of the carriers can be reduced. However, by the technique of the Patent document 1, it is difficult to take the carriers out (transfer) from the quantum dots; therefore, improvement of the photoelectric conversion efficiency of the solar cell is difficult. This problem is hard to be solved even by a combination of the techniques of the Patent document 1 with the technique of the Patent documents 2 and 3 in which quantum dots are produced in the wetting layer.

Accordingly, an object of the present invention is to provide a solar cell from which an electric current can be taken out by transferring carriers while obtaining phonon bottleneck effects of quantum dots.
The object is solved by the features of the independent claims. The dependent claims are directed to preferred embodiments of the invention.

Here, the phrase "be connected directly" means that the negative electrode and the wetting layer are connected in a manner to contact with each other without sandwiching any other layers or the positive electrode and the wetting layer are connected in a manner to contact with each other without sandwiching any other layers.

Here, in the invention, the phrase "interaction of a plurality of the electrons" means an action where two or more electrons collide each other. In addition, in the invention, the phrase "interaction of a plurality of the holes" means an action where two or more holes crash each other.

### Effects of the Invention

According to the present invention, since the quantum dots are used, it is possible to lock carriers generated by irradiation of light into the quantum dots; thereby it is possible to obtain the phonon bottleneck effect of the quantum dots. Moreover, the negative electrode is connected with the quantum dots through at least the wetting layer. So, the carriers locked in the quantum dots can be transferred to the wetting layer, and then the carriers existing in the wetting layer can be transferred to the negative electrode. The wetting layer has a thickness equivalent to one or two layers of molecule; therefore, carriers having a specific energy can only exist. Accordingly, the invention can provide a solar cell from which an electric current can be taken out by transferring carriers while obtaining phonon bottleneck effects of the quantum dots.

In addition the wetting layer can also function as an electron-traveling layer or a hole-traveling layer. Because of this, by connecting directly the negative electrode or the positive electrode with the wetting layer, it is possible to provide a solar cell from which an electric current can be taken out by transferring carriers while obtaining phonon bottleneck effects of the quantum dots.

Further, by employing the electron-traveling layer or the hole-traveling layer, in addition to the above effects, it is possible to surely select carriers reaching the negative electrode or the positive electrode.

Still further, by employing the electron mixing layer, in addition to the above effects, it is possible to easily transfer the carriers from the wetting layer to the negative electrode.

Still further, by connecting the wetting layer formed obliquely against the horizontal plane with the negative electrode or the positive electrode disposed substantially horizontally, in addition to the above effects, it is possible to easily produce the solar cell.

Still further, by connecting a plurality of the wetting layer with the negative electrode or the positive electrode, in addition to the above effects, it is further possible to increase the light to be absorbed by the first material layer and the second material layer; thereby possible to easily improve the photoelectric conversion efficiency.

Still further, by connecting the negative electrode or the positive electrode disposed in the recess portion with a plurality of the wetting layers, it is possible to increase the light to be absorbed by the first material layer and the second material layer; thereby it is possible to easily improve the photoelectric conversion efficiency.

According to a further embodiment of the invention, the wetting layer is connected with the negative electrode through the electron-traveling layer, and the wetting layer is connected with the positive electrode through the hole-traveling layer. Since quantum dots are employed, it is possible to obtain the phonon bottleneck effect of the quantum dots even by the second aspect of the invention. In addition, the invention can transfer electrons which have been transferred from the quantum dots to the wetting layer to the negative electrode; and the the invention can also transfer the holes which have been transferred from the quantum dot to the wetting layer to the positive electrode. Accordinglyit is possible to provide a solar cell from which an electric current can be taken out by transferring carriers while obtaining phonon bottleneck effects of quantum dots.

Moreover, by connecting the electron-traveling layer and the wetting layer through the electron mixing layer, in addition to the above effects, it is possible to easily transfer the electrons from the wetting layer to the negative electrode.

Still further, by connecting the wetting layer formed obliquely against the horizontal plane with the negative electrode and the positive electrode disposed substantially horizontally through at least the electron-traveling layer and the hole-traveling layer respectively, it is possible to easily produce the solar cell.

Still further, by connecting a plurality of the wetting layer with the negative electrode and the positive electrode through at least the electron-traveling layer and the hole-traveling layer respectively, in addition to the above effects, it is possible to increase the light to be absorbed by the first material layer and the second material layer; thereby it is possible to easily improve the photoelectric conversion efficiency.

Still further, with the invention comprising a plurality of the first material layers and the second material layers, even by connecting a plurality of the wetting layers to the negative electrode disposed in the recess portion and the positive electrode disposed in the other recess portion through at least the electron-traveling layer and the hole-traveling layer respectively, it is possible to increase the light to be absorbed by the first material layer and the second material layer; thereby it is possible to easily improve the photoelectric conversion efficiency.

Still further, due to the difference between the bandgap of the first material layer and the bandgap of the second material layer being 1 eV or more, in addition to the above effects, carriers generated by irradiation of light can be easily locked in the quantum dots.

### Brief Description of the Drawings

Fig. 1 is a cross-sectional view of an example of a solar cell 10 useful for understanding the invention;
Fig. 2 is a cross-sectional view of the solar cell 10;
Fig. 3 is a cross-sectional view of an embodiment of a solar cell 20;
Fig. 4 is a band diagram showing a band structure of the solar cell 20;
Fig. 5 is a cross-sectional view of an embodiment of a solar cell 30;
Fig. 6 is a cross-sectional view of an embodiment of a solar cell 40; and
Fig. 7 is a plan showing an example of a step included in a production process of the solar cell 40.

### Description of the Reference Numerals

- 1: first material layer
- 1a: wetting layer
- 1b: quantum dot
- 2: second material layer
- 3: stacked body
- 4: recess portion
- 5: negative electrode
- 6: hole-traveling layer
- 6a: energy barrier
- 6b: energy barrier
- 7: positive electrode
- 8: electron-traveling layer
- 8a: energy barrier
- 8b: energy barrier
- 10: solar cell
- 20: solar cell
- 30: solar cell
- 31: hole-traveling layer
- 32: positive electrode
- 40: solar cell
- 41: first material layer
- 41a: wetting layer
- 41b: quantum dot
- 42: second material layer
- 43: stacked body
- 44: electron-traveling layer
- 45: negative electrode
- 46: hole-traveling layer
- 47: positive electrode
- 48: layer
- 49: layer
- 50: layer

### Best Mode for Carrying Out the Invention

A quantum dot solar cell, for example, locks electrons generated by irradiation of light in quantum dots and employs the phonon bottleneck effect of the quantum dots. Because of this, bandwidth range of absorbable solar spectrum can be increased. Therefore, in a quantum dot solar cell, it is necessary to lock the carriers in the quantum dots. However, when the carriers are kept locked in the quantum dots and prevented from moving from the quantum dots to an electrode, the electric current cannot be taken out. As a result, it is difficult to improve the photoelectric conversion efficiency. So, in order to improve the photoelectric conversion efficiency of a quantum dot solar cell, it is necessary to transfer the carriers from the quantum dots while keeping the effect for locking the carriers in the quantum dots maximum. To solve the problem, it is presumably effective to limit the energy range of the carriers taken out from the quantum dots.

Meanwhile, when depositing, on a surface of a semiconductor X having a large bandgap, a semiconductor Y having a larger lattice constant than and smaller bandgap than those of the semiconductor X at nanometer scale by molecular beam epitaxy method and so on, nanometer scale particles (quantum dots) can be produced on the layer of the semiconductor Y (wetting layer) having a thickness equivalent to one or two layers of molecule formed on the surface of the semiconductor X. This method is called "Stranski-Krastanov (SK) Growth Mode (or SK mode)"; quantum dots produced by SK mode are connected to the wetting layer. As described above, the wetting layer is extremely thin, so that the quantum effect is strong; thereby carriers having a specific energy can only exist in the wetting layer.

As a result of the intensive study by the inventors, they discovered that it is possible to transfer the carriers from the quantum dot while keeping the effect obtained by locking carriers in the quantum dots (phonon bottleneck effect) maximum, by using the wetting layer connected to the quantum dots. Moreover, the inventors also discovered that it is possible to transfer the carriers which have been transferred to the wetting layer to the negative electrode or the positive electrode by connecting the wetting layer connected to the quantum dot with electrode(s) (negative electrode and/or positive electrode); thereby possible to take out the electric current.

Thus, the inventors arrived at the present invention. The main object of the present invention is to provide a solar cell with a structure where a wetting layer connected to the quantum dots is connected with negative electrode and/or positive electrode directly or indirectly, which is capable of taking out electric current by transferring carriers while obtaining phonon bottleneck effect of the quantum dots.

Hereinafter, the present invention will be described with reference to the drawings. It should be noted that the embodiments shown below are examples of this invention, therefore the invention is not limited by these embodiments.

### 1. Example useful for understanding the invention

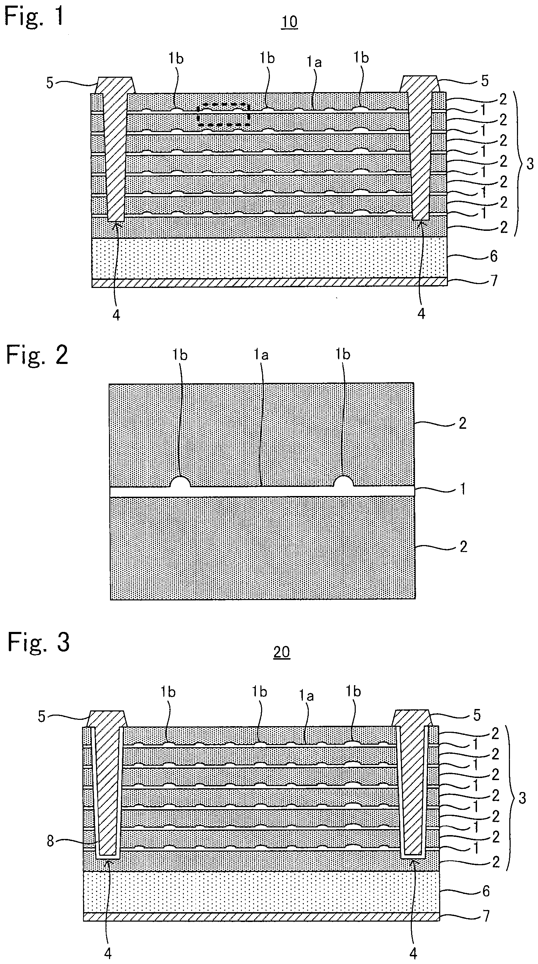

Fig. 1 is a cross-sectional view of an example of a solar cell 10. In Fig. 1, a part of the solar cell 10 is extracted and enlarged. In Fig. 1, a part of the reference numerals are not shown. Fig. 2 is a plan enlarging an area of Fig. 1 selected by the dotted line. As shown in Figs. 1 and 2, the solar cell 10 comprises: a stacked body 3 comprising a plurality of first material layers 1, 1, ... and a plurality of second material layers 2, 2, ...; negative electrodes 5, 5 disposed in recess portions 4, 4 formed in the stacked body 3; a hole-traveling layer 6 arranged at the lower side of the stacked body 3 in a manner to contact with the second material layer 2; and a positive electrode 7 arranged at the lower side of the hole-traveling layer 6 in a manner to contact with the hole-traveling layer 6. In the solar cell 10, the first material layers 1, 1, ... is made of a semiconductor (i.e. a semiconductor equivalent to the above-described semiconductor Y.) of which lattice constant is larger than and band gap is smaller than those of the semiconductor constituting the second material layers 2, 2, ... (i.e. a semiconductor equivalent to the above-described semiconductor X.). The first material layer 1 comprises: a wetting layer 1a; and quantum dots 1b, 1b, ... connected to the wetting layer 1a. A plurality of the wetting layer 1a, 1a, ... and the negative electrodes 5, 5 are directly connected. In the solar cell 10, the first material layers 1, 1, ... are formed of InN, the second material layers 2, 2, ... are formed of p-doped GaN, and the hole-traveling layer 6 is formed of strongly p-doped AlGaN. In other words, in the solar cell 10, the first material layers 1, 1, ... are equivalent to n-layer, the second material layers 2, 2, ... are equivalent to p-layer, and the hole-traveling layer 6 is equivalent to p⁺-layer. In the solar cell 10, the quantum dots 1b, 1b, ... have a height of about 1-10 nm and a diameter of about 10-100 nm.

By the solar cell 10, it is possible to lock electrons generated in the stacked body 3 by irradiation of light into the quantum dots 1b, 1b, ..., so the phonon bottleneck effect of the quantum dots 1b, 1b, ... can be obtained. Since the wetting layers 1a, 1a, ... connected with the quantum dots 1b, 1b, ... are extremely thin, the quantum effect is strong. Because of this, only electrons having higher energy than the energy of the bottom conduction band of the semiconductor Y can exist in the wetting layer 1a, 1a, .... Accordingly, in the solar cell 10, among the electrons locked in the quantum dots 1b, 1b, ..., only electrons having energy enough to travel to the wetting layers 1a, 1a, ... can be transferred to the wetting layers 1a, 1a, .... Moreover, in the solar cell 10, the wetting layers 1a, 1a, ... and the negative electrodes 5, 5 are connected directly. Due to this, with the solar cell 10, the electrons which have been transferred to the wetting layers 1a, 1a, ... can be transferred to the negative electrodes 5, 5. That is, with the solar cell 10, it is possible to take out the electrons locked in the quantum dots 1b, 1b, ... through the wetting layers 1a, 1a, ....

Holes generated by irradiating the solar cell 10 with light can be transferred from the first material layers 1, 1, ... to the second material layers 2, 2, ...; the holes can also be transferred from the second material layers 2, 2, ... to the first material layers 1, 1, .... By electric field induced by p-doping of the hole-traveling layer 6, an acceleration force is given towards the hole-traveling layer 6. Because of this, holes existing in the stacked body 3 can travel from the upper side to the lower side of the sheet of Fig. 1; and then, those holes can reach the positive electrode 7 through the hole-traveling layer 6 capable of preventing passage of electrons.

In this way, with the solar cell 10, it is possible to transfer the electrons generated in the stacked body 3 by irradiation of light to the negative electrodes 5, 5 through the wetting layers 1a, 1a, ... while obtaining the phonon bottleneck effect of the quantum dots 1b, 1b, ...; it is also possible to transfer the holes generated in the stacked body 3 to the positive electrode 7. Consequently, it is possible to provide the solar cell 10 which is capable of taking electric current out by transferring electrons while obtaining phonon bottleneck effect of the quantum dots 1b, 1b, ....

With regard to the solar cell 10, the stacked body 3 can be produced in accordance with the following procedures. That is, first of all, the second material layer 2 constituted by a semiconductor (i.e. a semiconductor equivalent to the above-described semiconductor X.) having a smaller lattice constant than and having a larger bandgap than those of the semiconductor constituting the first material layer 1 (i.e. a semiconductor equivalent to the above-described semiconductor Y.) is formed on the surface of the hole-traveling layer 6. Then, on the surface of the formed second material layer 2, the first material layer 1 having a wetting layer 1a and quantum dots 1b, 1b, ... produced in the wetting layer 1a is formed by depositing the semiconductor (i.e. a semiconductor equivalent to the above-described semiconductor Y.) at nanometer scale by using
SK mode method. When formation of the second material layer 2 and the first material layer 1 are completed in this way, steps of forming another second material layer 2 on the surface of the first material layer 1 and then forming another first material layer 1 on the surface of the another second material layer 2 are repeated to produce the stacked body 3. When the stacked body 3 is produced, for example, recess portions 4, 4 are formed by etching the surface of the stacked body 3 with a suitable mask, grinding the surface of the stacked body 3 by using electron beam or ion beam, or other methods; then, a material constituting the negative electrodes 5, 5 (for instance, it is a material which can form a transparent electrode. Hereinafter, it is the same.) is deposited in the formed recess portion 4, 4. By producing the solar cell 10 in accordance with the above procedures, it is possible to connect a plurality of wetting layers 1a, 1a, ... with negative electrode 5, 5 directly.

### 2. First embodiment

Fig. 3 is a cross-sectional view of an example of a solar cell 20 according to the first embodiment. In Fig. 3, a part of the solar cell 20 is extracted and enlarged. In Fig. 3, a part of the reference numerals are not shown. Further, in Fig. 3, to the elements having the same structure as those in the solar cell 10, the same reference numerals as those used in Fig. 1 are given and the explanation thereof is omitted.

As shown in Fig. 3, the solar cell 20 comprises: a stacked body 3 comprising a plurality of first material layers 1, 1, ... and a plurality of second material layers 2, 2, ...; electron-traveling layers 8, 8 and negative electrodes 5, 5 respectively disposed in recess portions 4, 4 formed in the stacked body 3; a hole-traveling layer 6 arranged at the lower side of the stacked body 3 in a manner to contact with the second material layer 2; and a positive electrode 7 arranged at the lower side of the hole-traveling layer 6 in a manner to contact with the hole-traveling layer 6. The first material layer 1 comprises: a wetting layer 1a; and quantum dots 1b, 1b, ... connected to the wetting layer 1a. The electron-traveling layers 8, 8 are disposed between a plurality of the wetting layers 1a, 1a, ... and the negative electrodes 5, 5, wherein the plurality of the wetting layer 1a, 1a, ... and the negative electrodes 5, 5 are connected through the electron-traveling layers 8, 8. In the solar cell 20, the first material layers 1, 1, ... are formed of InN and the second material layers 2, 2, ... are formed of p-doped GaN. In addition, in the solar cell 20, the electron-traveling layers 8, 8 are formed of n-doped GaN; the hole-traveling layer 6 is formed of strongly p-doped AlGaN. In other words, in the solar cell 20, the first material layers 1, 1, ... are equivalent to n-layer, the second material layers 2, 2, ... are equivalent to p-layer, the electron-traveling layers 8, 8 are equivalent to n⁺-layer, and the hole-traveling layer 6 is equivalent to p⁺-layer. In the solar cell 20, the quantum dots 1b, 1b, ... have a height of about 1-10 nm and a diameter of about 10-100 nm.

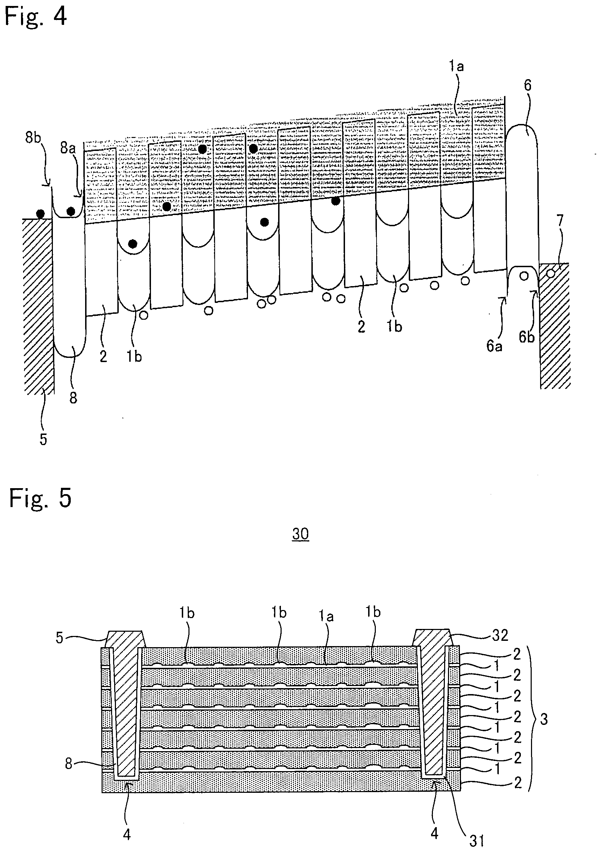

Fig. 4 is a band diagram showing a band structure of the solar cell 20. The upper side of Fig. 4 corresponds to high energy level and the lower side of Fig. 4 corresponds to low energy level; the left-and-right axis of Fig. 4 corresponds to the thickness of each elements of the solar cell 20 excluding the wetting layers 1a, 1a, .... In Fig. 4, the black dot (•) is an electron and the white dot (o) is a hole.

As shown in Fig. 4, the energy level of the bottom of conduction band of the second material layers 2, 2, ... is higher than that of the quantum dots 1b, 1b,.... The energy level at the top of the valence band of the second material layers 2, 2, ... is lower than that of the quantum dots 1b, 1b, .... By the influence of internal electric field generated in the solar cell 20, the energy level at the bottom of conduction band and the energy level at the top of the valence band of the second material layers 2, 2, ... incline; holes generated by p-doping of the second material layers 2, 2, ... are caught by the quantum dots; and then, by the Coulomb energy derived from the positive charge of the holes, the energy level at the bottom of conduction band of and the energy level at the top of the valence band of the quantum dots 1b, 1b, ... are curved to be convex downwardly. Meanwhile, as shown in Fig. 4, the energy level at the bottom of conduction band of the wetting layers 1a, 1a, ... is lower than that of the second material layers 2, 2, ... and higher than that of the quantum dots 1b, 1b, .... Because of this, among the electrons existing in the quantum dots 1b, 1b, ..., electrons having energy equivalent to the energy level at the bottom of conduction band of the quantum dots 1b, 1b, ... can be transferred to the wetting layers 1a, 1a, ... by raising energy by receiving energy from high-energy electrons existing in the quantum dots 1b, 1b, .... With this configuration, it is possible to inhibit energy loss of the carriers (i.e. electrons in the solar cell 20.) locked in the quantum dots 1b, 1b, ...; thus, by the solar cell 20 which takes the carriers out through the wetting layers 1a, 1a, ..., it is possible to reduce energy to be lost in the form of heat.

Moreover, as shown in Fig. 4, the energy level at the bottom of conduction band of the electron-traveling layer 8 is lower than that of the second material layers 2, 2, ... and higher than that of the quantum dots 1b, 1b, .... The energy level at the top of the valence band of the electron-traveling layer 8 is lower than that of the second material layers 2, 2, .... In addition, due to the influence of n-doping, the energy level at the bottom of conduction band and the energy level at the top of the valence band of the electron-traveling layer 8 are curved to be convex downwardly. This can be explained as follows. In other words, when many electrons produced by strong n-doping of the electron-traveling layer 8 depart from the electron-traveling layer 8 and are caught by the wetting layers 1a, 1a, ..., the electron-traveling layer 8 loses electrons. As a result, the electron-traveling layer 8 is charged positively; by the Coulomb energy derived from the charging, the energy level at the bottom of conduction band is curved to be convex downwardly. The lowermost part of the energy level reaches the bottom of the energy level of the wetting layers 1a, 1a, .... In this way, by making the energy level at the top of the valence band of the electron-traveling layer 8 curve to be convex downwardly, the solar cell 20 enables to have a structure in which the holes existing in the stacked body 3 cannot pass through the electron-traveling layer 8. In addition, in the solar cell 20, by producing the electron-traveling layer 8 with strong n-doping, thickness of the energy barrier 8a existing in the interface between the wetting layer 1a and the electron-traveling layer 8 and thickness of the energy barrier 8b existing in the interface between the electron-traveling layer 8 and the negative electrode 5 are made thinner. With this configuration of the solar cell 20, it is possible to make electrons pass through the energy barriers 8a, 8b by the tunnel effect.

Further, as shown in Fig. 4, the energy level at the bottom of conduction band of the hole-traveling layer 6 is higher than that of the second material layers 2, 2, ... and the energy level at the top of the valence band of the hole-traveling layer 6 is lower than that of the second material layers 2, 2, .... Due to the influence of p-doping, the energy level at the bottom of conduction band and the energy level at the top of the valence band of the hole-traveling layer 6 are curved to be convex upwardly. By making the energy level at the bottom of conduction band of the hole-traveling layer 6 curve to be convex upwardly, the solar cell 20 enables to have a structure in which the electrons existing in the stacked body 3 cannot pass through the hole-traveling layer 6. In addition, in the solar cell 20, by producing the hole-traveling layer 6 with strong p-doping, thickness of the energy barrier 6a existing in the interface between the second material layer 2 and the hole-traveling layer 6 and the thickness of the energy barrier 6b existing in the interface between the hole-traveling layer 6 and the positive electrode 7 are made thinner. With this configuration of the solar cell 20, it is possible to make holes pass through the energy barriers 6a, 6b by the tunnel effect easily caused by the sufficiently thin energy barriers 6a, 6b.

In this way, with the solar cell 20, it is possible to transfer the electrons locked in the quantum dots 1b, 1b, ... to the negative electrodes 5, 5 through the wetting layers 1a, 1a, ... and the electron-traveling layers 8, 8. With the embodiment including electron-traveling layers 8, 8, ..., access of the holes to the negative electrodes 5, 5 can be surely prevented. Accordingly, by the embodiment of the present invention, it is possible to provide the solar cell 20 which is not only capable of attaining the effect of the solar cell 10 but also capable of increasing the number of electrons reaching the negative electrodes 5, 5.

In the solar cell 20, the electron-traveling layers 8, 8 can be produced by, for example, depositing n-doped GaN on the surface of the recess portions 4, 4 formed in the same manner as that of the solar cell 10. Then, the negative electrodes 5, 5 in the solar cell 20 can be produced by depositing a material constituting the negative electrodes 5, 5 on the surface of the electron-traveling layers 8, 8 thus obtained. By producing the soclar cell 20 through the processes, a plurality of wetting layers 1a, 1a, ... can be connected with the negative electrodes 5, 5 through the electron-traveling layers 8, 8.

The above description regarding the solar cell 20 shows an example directly connecting the electron-traveling layers 8, 8 and the wetting layers 1a, 1a, ...; however, the solar cell of the present invention is not limited to this example. The electron-traveling layer and the wetting layer may be connected through an electron mixing layer which activates interaction of the plurality of electrons. When the electron mixing layer exists between an electron-traveling layer and an wetting layer, the electron mixing layer is set so that the energy level at the bottom of conduction band is lower than the energy level at the bottom of conduction band of the second material layers 2, 2, ..., higher than the energy level at the bottom of conduction band of the quantum dots 1b, 1b, ..., and slightly lower than the energy level at the bottom of conduction band of the wetting layers 1a, 1a, .... With this configuration, the electrons which have been transferred from the quantum dots 1b, 1b, ... to the wetting layers 1a, 1a, ... can be further transferred to the electron mixing layer. Then, by colliding the plurality of electrons transferred to the electron mixing layer, the interaction of the electrons can be actuated. The energy level at the top of the valence band of the electron mixing layer is, for example, equivalent to the energy level at the top of the valence band of the second material layers 2, 2, ...; by using an electron mixing layer positively charged by n-doping, the energy level at the bottom of conduction band and the energy level at the top of the valence band of the electron mixing layer can be curved to be convex downwardly. Such an electron mixing layer can be constituted by, for example, InₓGa₁₋ₓN (0.2 ≤ x ≤ 0.8).

The above description regarding the solar cells 10, 20 of the present invention shows embodiments in which the wetting layers 1a, 1a, ... and the negative electrode 5 are connected but the wetting layers 1a, 1a, ... and the positive electrode 7 are not connected; however, the present invention is not limited to these embodiments. The solar cell of the invention may be the one where the wetting layer and the positive electrode are connected but the wetting layer and the negative electrode are not connected. In this case, hole-traveling layer capable of preventing passage of electrons can be disposed between the wetting layer and the positive electrode; a hole mixing layer which can activate the interaction of a plurality of holes is preferably disposed between hole-traveling layer and the wetting layer.

Moreover, the solar cell of the invention is not limited to only the configuration where the wetting layer is connected with the negative electrode or the positive electrode; the solar cell may have a form where the wetting layer is connected to the negative electrode and the positive electrode.

Hereinafter, a solar cell of the invention having a form where the wetting layer is connected to the negative electrode and the positive electrode will be described in detail.

### 3. Third embodiment

Fig. 5 is a cross-sectional view of an example of a solar cell 30 according to the third embodiment. In Fig. 5, a part of the solar cell 30 is extracted and enlarged. In Fig. 5, a part of the reference numerals are not shown. Further, in Fig. 5, to the elements having the same structure as those in the solar cell 10, the same reference numerals as those used in Fig. 1 are given and the explanation thereof is omitted.

As shown in Fig. 5, the solar cell 30 comprises: a stacked body 3 comprising a plurality of first material layers 1, 1, ... and a plurality of second material layers 2, 2, ...; an electron-traveling layer 8 and a negative electrode 5 respectively disposed in one side of the recess portions 4 of the stacked body 3; and a hole-traveling layer 31 and a positive electrode 32 respectively disposed in the other side of the recess portions 4 of the stacked body 3. The first material layer 1 comprises: a wetting layer 1a; and quantum dots 1b, 1b, ... connected to the wetting layer 1a. Then, an electron-traveling layer 8 is disposed between a plurality of the wetting layers 1a, 1a, ... and the negative electrode 5; a hole-traveling layer 31 is disposed between a plurality of the wetting layers 1a, 1a, ... and the positive electrode 32. Because of this, in the solar cell 30, the plurality of the wetting layers 1a, 1a, ... and the negative electrode 5 are connected through the electron-traveling layer 8 and the plurality of the wetting layers 1a, 1a, ... and the positive electrode 32 are connected through the hole-traveling layer 31. In the solar cell 30, the first material layers 1, 1, ... are formed of InN and the second material layers 2, 2, ... are formed of p-doped GaN. In addition, in the solar cell 30, the electron-traveling layer 8 is formed of n-doped GaN; the hole-traveling layer 31 is formed of strongly p-doped AlGaN. In other words, in the solar cell 30, the first material layers 1, 1, ... are equivalent to n-layer, the second material layers 2, 2, ... are equivalent to p-layer, the electron-traveling layer 8 is equivalent to n⁺-layer, and the hole-traveling layer 31 is equivalent to p⁺-layer. In the solar cell 30, the quantum dots 1b, 1b, ... have a height of about 1-10 nm and a diameter of about 10-100 nm.

As seen above, even when the embodiment has a configuration in which the wetting layers 1a, 1a, ... is connected to the negative electrode 5 and the positive electrode 32, by arranging the electron-traveling layer 8 between the wetting layers 1a, 1a, ... and the negative electrode 5 and also arranging the hole-traveling layer 31 between the wetting layers 1a, 1a, ... and the positive electrode 32, it is possible to transfer only electrons existing in the stacked body 3 to the negative electrode and possible to transfer only holes existing in the stacked body 3 to the positive electrode 32. That is, by the solar cell 30, it is possible to transfer the electrons locked in the quantum dots 1b, 1b, ... to the negative electrode 5 through the wetting layers 1a, 1a,.... In addition, in the solar cell 30, the wetting layers 1a, 1a, ... and the positive electrode 32 are connected through the hole-traveling layer 31. Due to this, by the solar cell 30, it is possible to transfer the holes locked in the quantum dots 1b, 1b, ... to the positive electrode 32 through the wetting layers 1a, 1a, .... Accordingly, with the configuration in which the wetting layers 1a, 1a, ... is connected to the negative electrode 5 and the positive electrode 32, the present invention can provide the solar cell 30 which is capable of obtaining phonon bottleneck effect of the quantum dots 1b, 1b, ... and capable of taking electric current out by transferring the electrons and holes to the negative electrode 5 or the positive electrode 32, respectively.

The solar cell 30 can be produced, for example, by the steps of: producing a stacked body 3 having recess portions 4, 4 in the same manner as that of the solar cell 10; forming an electron-traveling layer 8 by depositing n-doped GaN in one side of the recess portion 4; and depositing a material constituting the negative electrode 5 on the surface of the formed electron-traveling layer 8 by depositing n-doped GaN in one side of the recess portion 4; and depositing a material constituting the negative electrode 5 on the surface of the formed electron-traveling layer 8. Through the process, it is possible to connect the negative electrode 5 and a plurality of the wetting layers 1a, 1a, ... through the electron-traveling layer 8. In addition, by forming the hole-traveling layer 31 in the other side of the recess portion 4 by depositing strongly p-doped AlGaN and further depositing a material constituting the positive electrode 32 (for instance, a material which can form a transparent electrode) on the surface of the formed hole-traveling layer 31, it is possible to connect the positive electrode 32 and the plurality of the wetting layers 1a, 1a, ... through the hole-traveling layer 31.

The above description regarding the solar cells 10, 20, 30 shows examples in which the hole-traveling layer 6 or the hole-traveling layer 31 is formed of a strongly p-doped AlGaN; however, the solar cell of the invention is not limited thereto. The hole-traveling layer provided in the solar cell of the invention may be formed of other materials such as strongly p-doped GaN.

Moreover, the above description regarding the solar cells 10, 20, 30 of the present invention shows embodiments in which a recess portion 4 has a deep opening with small diameter (for example, depth of several hundred nanometer); however, the solar cell of the invention is not limited to these embodiments. The recess portion provided to the solar cell of the invention may have a shallow opening with larger diameter (for example, depth of several micrometer or more).

Further, the above description regarding the solar cells 10, 20, 30 shows examples comprising: the negative electrode 5 and the positive electrode 7 or the positive electrode 32 respectively disposed horizontally; and the stacked body 3 having the first material layers 1, 1, ... and the second material layers 2, 2, ... respectively formed horizontally. However, the solar cell of the invention is not limited thereto. So, hereinafter, an embodiment of the solar cell of the present invention comprising: a first material layer and a second material layer respectively formed in a manner to oblique against the horizontal plane; and a negative electrode and a positive electrode respectively disposed horizontally will be described in detail.

### 4. Third embodiment

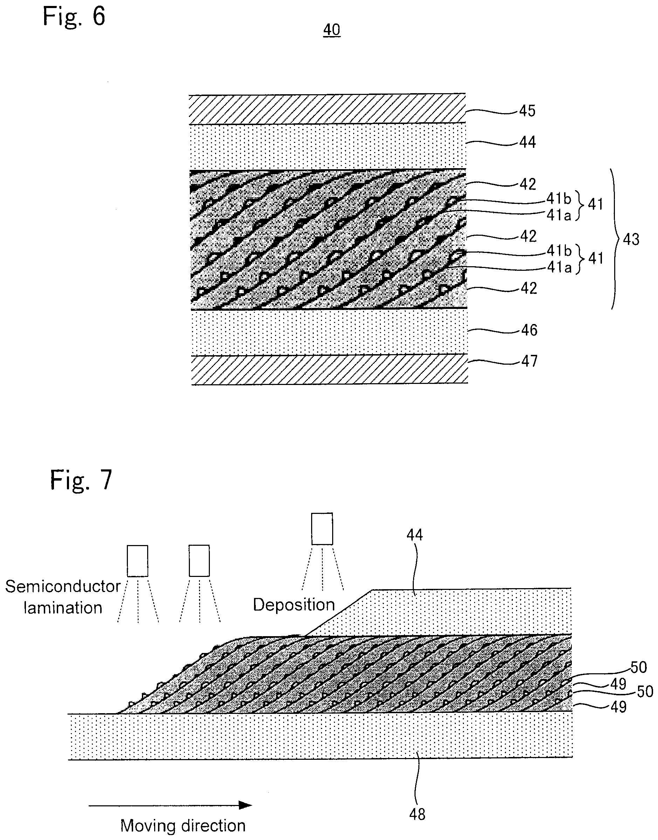

Fig. 6 is a cross-sectional view of an example of a solar cell 40 according to the third embodiment. In Fig. 6, a part of the solar cell 40 is extracted and enlarged. In Fig. 6, a part of the reference numerals are not shown.

As shown in Fig. 6, the solar cell 40 comprises: a stacked body 43 comprising a plurality of first material layers 41, 41, ... and a plurality of second material layer 42, 42, ... respectively formed obliquely against the horizontal plane; an electron-traveling layer 44 substantially horizontally disposed on the upper face of the stacked body 43 in a manner to contact with the stacked body 43; a negative electrode 45 substantially horizontally disposed on the upper face of the electron-traveling layer 44 in a manner to contact with the electron-traveling layer 44; a hole-traveling layer 46 substantially horizontally disposed. on the lower face of the stacked body 43 in a manner to contact with the stacked body 43; and a positive electrode 47 substantially horizontally disposed on the lower face of the hole-traveling layer 46 in a manner to contact with the hole-traveling layer 46. The first material layer 41 comprises: a wetting layer 41a which is formed obliquely against the horizontal plane; and quantum dots 41b, 41b, ... connected to the wetting layer 41a. In the solar cell 40, the first material layers 41, 41, ... are formed of InAs; the second material layers 42, 42, ... are formed of p-doped GaAs. Further, in the solar cell 40, the electron-traveling layer 44 is formed of n-doped GaAs; the hole-traveling layer 46 is formed of strongly p-doped GaAs. In other words, in the solar cell 40, the first material layers 41, 41, ... are equivalent to n-layer, the second material layers 42, 42, ... are equivalent to p-layer, the electron-traveling layer 44 is equivalent to n⁺-layer, and the hole-traveling layer 46 is equivalent to p⁺-layer. In the solar cell 40, the quantum dots 41b, 41b, ... have a height of about 1-10 nm and a diameter of about 10-100 nm.

As seen above, in the solar cell 40, the plurality of the wetting layers 41a, 41a, ... respectively formed obliquely against the horizontal plane and the negative electrode 45 substantially horizontally disposed are connected through the electron-traveling layer 44; the plurality of the wetting layers 41a, 41a, ... respectively formed obliquely against the horizontal plane and the positive electrode 47 substantially horizontally disposed are connected through the hole-traveling layer 46. By the solar cell 40 with this configuration, it is possible to connect the plurality of the wetting layer to the negative electrode and the positive electrode, without forming the recess portion. Accordingly, with the embodiment of the present invention, it is possible to provide the solar cell 40 which is not only capable of attaining the effect of the solar cell 30 but also capable of improving the productivity.

Fig. 7 is a plan showing an example of a step included in a production process of the solar cell 40. In Fig. 7, a part of the production process of the stacked body 43 to be formed obliquely against the horizontal plane and a production process for forming the electron-traveling layer 44 on the stacked body 43 are shown in a simplified manner. In Fig. 7, a part of the reference numerals are not shown.

As shown in Fig. 7, when forming the stacked body 43, for example, first of all, a layer 48 formed of strongly p-doped GaAs (i.e. a layer equivalent to the hole-traveling layer 46. Hereinafter, it is the same.) is produced on a predetermined substrate. Then, by depositing p-doped GaAs on the layer 48 while transferring a table on which the layer 48 is mounted from the left side to the right side of the sheet of Fig.7, a layer 49 of which upper face inclines against the horizontal plane (i.e. a layer equivalent to the second material layer 42. Hereinafter, it is the same.) is produced. When the production of the layer 49 of which upper face inclines against the horizontal plane is completed in this way, a layer 50 which inclines against the horizontal plane (i.e. a layer equivalent to the first material layer 41. Hereinafter, it is the same.) is produced by depositing InAs while transferring a table on which the layer 48, the layer 49, and so on are mounted from the left side to the right side of the sheet of Fig.7. After this, by forming the layer 49 of which upper face inclines against the horizontal plane on the surface of the layer 50 and then forming the layer 50 of which upper face inclines against the horizontal plane on the surface of the layer 49 repeatedly, a stacked body comprising a plurality of the layers 49 and a plurality of the layer 50 (hereinafter, referred to as "stacked body Z".) can be produced. When the production of the stacked body Z is completed, the stacked body Z is cut into pieces each having a predetermined size, to produce the stacked body 43 comprising: a plurality of the first material layers 41 having the wetting layers 41a formed of InAs and the quantum dots 41b, 41b, ...; and a plurality of the second material layers 42 formed of p-doped GaAs. When forming the electron-traveling layer 44, as shown in Fig. 7, for example, n-doped GaAs is simply deposited on the upper face of the stacked body Z before completion of production of the stacked body Z. The negative electrode 45 can be formed by depositing a material constituting the negative electrode 45 (for example, a material for forming a transparent electrode) on the formed electron-traveling layer 44. The positive electrode 47 can be formed by depositing a material constituting the positive electrode 47 (for example, a material for forming a transparent electrode) on the other face of the hole-traveling layer 46 opposite to the stacked body 43. By producing the solar cell 40 through the processes, it is possible to connect a plurality of the wetting layers 41a, 41a, ... formed obliquely against the horizontal plane, the negative electrode 45 through the electron-traveling layer 44 and possible to connect a plurality of the wetting layers 41a, 41a, ... formed obliquely against the horizontal plane and the positive electrode 47 through the hole-traveling layer 46.

The above description regarding the solar cell 40 shows an embodiment provided with the first material layers 41, 41, ... formed of InAs and the second material layers 42, 42, ... formed of p-doped GaAs; the materials constituting the first material layer 41 and the second material layer 42 are not limited to the embodiment. The first material layer 41 may be formed of InN, for example; in this case, the second material layer 42 can be formed of p-doped GaN. In a case that the second material layer 42 is formed of p-doped GaN, a second material layer 42 inclined against the horizontal plane can be produced by the steps of, for example: forming a layer constituted by p-doped GaN on a surface of a sapphire substrate; and then depositing p-doped GaN while transferring the sapphire substrate on which the layer 42 is formed.

The above descriptions regarding the solar cells 30, 40 of the invention show an embodiment in which the electron-traveling layer 8 is disposed between the wetting layer 1a and the negative electrode 5 and the hole-traveling layer 31 is disposed between the wetting layer 1a and the positive electrode 32; and the description regarding the solar cell 40 of the invention shows an embodiment in which the electron-traveling layer 44 is disposed between the wetting layer 41a and the negative electrode 45 and the hole-traveling layer 46 is disposed between the wetting layer 41a and the positive electrode 47. Further, according to the present invention, an electron mixing layer which activates interaction of the electrons is arranged between the wetting layer and the negative electrode. In addition, a hole mixing layer which activates interaction of the holes is preferably arranged between the wetting layer and the positive electrode.

The above descriptions regarding the solar cells 10, 20, 30, 40 of the invention show embodiments comprising a plurality of the first material layer 1 or the first material layer 41 and a plurality of the second material layer 2 or the second material layer 42; however, the invention is not limited to these embodiments. The solar cell of the invention may have a configuration in which the first material layer and the second material layer are respectively formed of only one layer. It should be noted that in view of a configuration in which light can be easily absorbed into the stacked body having the first material layer and the second material layer, the configuration preferably comprises a plurality of the first material layer and a plurality of the second material layer.

In the solar cell of the present invention, the difference between the bandgap of a material constituting the first material layer and the bandgap of a material constituting the second material layer can be adequately selected within a range capable of obtaining each of the above effect. The difference between the bandgap of a material constituting the first material layer and the bandgap of a material constituting the second material layer is preferably larger. Specifically, it is preferably 1 eV or more, more preferably 2.5 eV or more.

### Industrial Applicability

The solar cell of the present invention can be used for, for example, power source of electric vehicles and photovoltaic system.

## Claims

1. A solar cell (20) comprising:
a first material layer (1) comprising a wetting layer (1a) and quantum dots (1b) formed in the wetting layer (1a);
a second material layer (2), wherein the first material layer (1) is formed on the surface of the second material layer (2);
a negative electrode (5); and
a positive electrode (7); wherein
the negative electrode (5) is connected with the wetting layer (1a) through an electron-traveling layer (8) capable of preventing passage of holes so that the electrons existing in the wetting layer (1 a) can travel to the negative electrode (5);
**characterized in that**
the electron-traveling layer (8) is connected with the wetting layer (1 a) through an electron mixing layer;
the electron mixing layer is set so that the energy level at the bottom of its conduction band is lower than the energy level at the bottom of the conduction band of the second material layer (2), higher than the energy level at the bottom of the conduction band of the quantum dots (1 b), and lower than the energy level at the bottom of the conduction band of the wetting layer (1a).

2. The solar cell (20) according to claim 1, wherein
a plurality of the first material layers (1) and a plurality of the second material layers (2) are provided and alternately stacked to form a stacked body (3), and
the negative electrode (5) and a plurality of the wetting layers (1 a) are connected so that the electrons existing in each of the plurality of the wetting layers (1 a) can travel to the negative electrode (5).

3. The solar cell (20) according to claim 2, wherein
the stacked body (3) comprising the plurality of the first material layers (1) and the plurality of the second material layers (2) has recess portion(s)(4), and
the negative electrode disposed in the recess portion (4) and the plurality of the wetting layers (1a) are connected through the electron-traveling layer (8) and the electron mixing layer.

4. A solar cell (30) comprising:
a first material layer (1) comprising a wetting layer (1 a) and quantum dots (1 b) produced in the wetting layer (1 a);
a second material layer (2), wherein the first material layer (1) is formed on the surface of the second material layer (2);
a positive electrode (7); and
a negative electrode (5); wherein
the negative electrode (5) and the wetting layer (1 a) are connected through an electron-traveling layer (8) capable of preventing passage of holes so that the electrons existing in the wetting layer (1a) can travel to the negative electrode (5), and
the positive electrode (7) and the wetting layer (1a) are connected through a hole-traveling layer (31) capable of preventing passage of electrons so that the holes existing in the wetting layer (1 a) can travel to the positive electrode (7);
**characterized in that**
the electron-traveling layer (8) is connected with the wetting layer (1 a) through an electron mixing layer; and
the electron mixing layer is set so that the energy level at the bottom of its conduction band is lower than the energy level at the bottom of the conduction band of the second material layer (2), higher than the energy level at the bottom of the conduction band of the quantum dots (1 b), and lower than the energy level at the bottom of the conduction band of the wetting layer (1a).

5. The solar cell (20, 30) according to any one of claims 1 to 4, wherein the difference between the bandgap of the first material layer (1) and the bandgap of the second material layer (2) is 1 eV or more.

## Patentansprüche

1. Solarzelle (20), die aufweist:
eine erste Materialschicht (1), die eine Benetzungsschicht (1a) und Quantenpunkte (1 b), die in der Benetzungsschicht (1a) ausgebildet sind, aufweist;
eine zweite Materialschicht (2), wobei die erste Materialschicht (1) auf der Oberfläche der zweiten Materialschicht (2) ausgebildet ist;
eine negative Elektrode (5); und
eine positive Elektrode (7); wobei
die negative Elektrode (5) mit der Benetzungsschicht (1a) über eine Elektronenbewegungsschicht (8) verbunden ist, die ein Passieren von Löchern verhindern kann, so dass die Elektronen, die in der Benetzungsschicht (1a) vorhanden sind, sich zu der negativen Elektrode (5) bewegen können;
**dadurch gekennzeichnet, dass**
die Elektronenbewegungsschicht (8) mit der Benetzungsschicht (1a) über eine Elektronenmischschicht verbunden ist;
die Elektronenmischschicht derart festgelegt ist, dass das Energieniveau an dem Boden ihres Leitungsbandes niedriger als das Energieniveau an dem Boden des Leitungsbandes der zweiten Materialschicht (2) ist, höher als das Energieniveau an dem Boden des Leitungsbandes der Quantenpunkte (1 b) ist, und niedriger als das Energieniveau an dem Boden des Leitungsbandes der Benetzungsschicht (1a) ist.

2. Solarzelle (20) nach Anspruch 1, wobei
mehrere der ersten Materialschichten (1) und mehrere der zweiten Materialschichten (2) abwechselnd vorhanden und gestapelt sind, um einen gestapelten Körper (3) auszubilden, und
die negative Elektrode (5) und mehrere der Benutzungsschichten (1a) derart verbunden sind, dass die Elektronen, die in den jeweiligen Benetzungsschichten (1a) vorhanden sind, sich zu der negativen Elektrode (5) bewegen können.

3. Solarzelle (20) nach Anspruch 2, wobei
der gestapelte Körper (3), der die ersten Materialschichten (1) und die zweiten Materialschichten (2) aufweist, einen oder mehrere Vertiefungsabschnitte (4) aufweist, und
die negative Elektrode, die in dem Vertiefungsabschnitt (4) angeordnet ist, und die Benetzungsschichten (1a) über die Elektronenbewegungsschicht (8) und die Elektronenmischschicht verbunden sind.

4. Solarzelle (30), die aufweist:
eine erste Materialschicht (1), die eine Benetzungsschicht (1a) und Quantenpunkte (1 b), die in der Benetzungsschicht (1a) erzeugt werden, aufweist;
eine zweite Materialschicht (2), wobei die erste Materialschicht (1) auf der Oberfläche der zweiten Materialschicht (2) ausgebildet ist;
eine positive Elektrode (7); und
eine negative Elektrode (5); wobei
die negative Elektrode (5) und die Benetzungsschicht (1a) über eine Elektronenbewegungsschicht (8) verbunden sind, die in der Lage ist, ein Passieren von Löchern zu verhindern, so dass die Elektronen, die in der Benetzungsschicht (1a) vorhanden sind, sich zu der negativen Elektrode (5) bewegen können, und
die positive Elektrode (7) und die Benetzungsschicht (1a) über eine Lochbewegungsschicht (31) verbunden sind, die in der Lage ist, ein Passieren von Elektronen zu verhindern, so dass die Löcher, die in der Benetzungsschicht (1a) vorhanden sind, sich zu der positiven Elektrode (7) bewegen können;
**dadurch gekennzeichnet, dass**
die Elektronenbewegungsschicht (8) mit der Benetzungsschicht (1a) über eine Elektronenmischschicht verbunden ist; und
die Elektronenmischschicht derart festgelegt ist, dass das Energieniveau an dem Boden ihres Leitungsbandes niedriger als das Energieniveau an dem Boden des Leitungsbandes der zweiten Materialschicht (2) ist, höher als das Energieniveau an dem Boden des Leitungsbandes der Quantenpunkte (1 b) ist, und niedriger als das Energieniveau an dem Boden des Leitungsbandes der Benetzungsschicht (1a) ist.

5. Solarzelle (20, 30) nach einem der Ansprüche 1 bis 4, wobei die Differenz zwischen der Bandlücke der ersten Materialschicht (1) und der Bandlücke der zweiten Materialschicht (2) gleich 1 eV oder mehr beträgt.

## Revendications

1. Pile solaire (20) comprenant :
une première couche de matériau (1) comportant une couche de mouillage (1a) et des points quantiques (1b) formés dans la couche de mouillage (la) ;
une deuxième couche de matériau (2), dans laquelle la première couche de matériau (1) est formée sur la surface de la deuxième couche de matériau (2) ;
une électrode négative (5) ; et
une électrode positive (7) ; dans laquelle
l'électrode négative (5) est connectée à la couche de mouillage (1a) par l'intermédiaire d'une couche de déplacement d'électrons (8) apte à empêcher le passage de trous de sorte que les électrons existant dans la couche de mouillage (la) peuvent se déplacer vers l'électrode négative (5) ;
**caractérisée en ce que**
la couche de déplacement d'électrons (8) est connectée à la couche de mouillage (1a) par l'intermédiaire d'une couche de mélange d'électrons,
la couche de mélange d'électrons est définie de sorte que le niveau énergétique au bas de sa bande de conduction est inférieur au niveau d'énergie au bas de la bande de conduction de la deuxième couche de matériau (2), supérieur au niveau énergétique au bas de la bande de conduction des points quantiques (1b) , et inférieur au niveau énergétique au bas de la bande de conduction de la couche de mouillage (1a).

2. Pile solaire (20) selon la revendication 1, dans laquelle
une pluralité des premières couches de matériau (1) et une pluralité des deuxièmes couches de matériau (2) sont prévues et empilées de manière alternée pour former un corps empilé (3), et
l'électrode négative (5) et une pluralité des couches de mouillage (1a) sont connectées de sorte que les électrons existant dans chacune de la pluralité des couches de mouillage (1a) peuvent se déplacer vers l'électrode négative (5).

3. Pile solaire (20) selon la revendication 2, dans laquelle
le corps empilé (3) comprenant la pluralité des premières couches de matériau (1) et la pluralité des deuxièmes couches de matériau (2) présente des parties évidées (4), et
l'électrode négative disposée dans la partie évidée (4) et la pluralité des couches de mouillage (1a) sont connectées par l'intermédiaire de la couche de déplacement d'électrons (8) et la couche de mélange d'électrons.

4. Pile solaire (30) comprenant :
une première couche de matériau '(1) comprenant une couche de mouillage (1a) et des points quantiques (1b) produits dans la couche de mouillage (1a) ;
une deuxième couche de matériau (2), dans laquelle la première couche de matériau (1) est formée sur la surface de la deuxième couche de matériau (2) ;
une électrode positive (7) ; et
une électrode négative (5) ; dans laquelle
l'électrode négative (5) et la couche de mouillage (1a) sont connectées par l'intermédiaire d'une couche de déplacement d'électrons (8) apte à empêcher le passage de trous de sorte que les électrons existant dans la couche de mouillage (1a) peuvent se déplacer vers l'électrode négative (5), et
l'électrode positive (7) et la couche de mouillage (1a) sont connectées par l'intermédiaire d'une couche de déplacement de trous (31) apte à empêcher le passage d'électrons de sorte que les trous existant dans la couche de mouillage (1a) peuvent se déplacer vers l'électrode positive (7) ;
**caractérisé en ce que**
la couche de déplacement d'électrons (8) est connectée à la couche de mouillage (1a) par l'intermédiaire d'une couche de mélange d'électrons ; et
la couche de mélange d'électrons est définie de sorte que le niveau énergétique au bas de sa bande de conduction est inférieur au niveau énergétique au bas de la bande de conduction de la deuxième couche de matériau (2), supérieur au niveau énergétique au bas de la bande de conduction des points quantiques (1b), et inférieur au niveau énergétique au bas de la bande de conduction de la couche de mouillage (1a).

5. Pile solaire (20, 30) selon l'une quelconque des revendications 1 à 4, dans laquelle la différence entre la bande interdite de la première couche de matériau (1) et la bande interdite de la deuxième couche de matériau (2) est supérieure ou égale à 1 eV.
